Europäisches Patentamt

European Patent Office

Office européen des brevets

(11) Veröffentlichungsnummer: **0 180 056**
**B1**

(12) **EUROPÄISCHE PATENTSCHRIFT**

(45) Veröffentlichungstag der Patentschrift: **09.01.91**

(21) Anmeldenummer: **85112551.8**

(22) Anmeldetag: **03.10.85**

(51) Int. Cl.⁵: **H 05 K 7/18, H 05 K 7/14**

(54) **Rückwandverdrahtung für elektrische Baugruppen.**

(30) Priorität: **31.10.84 DE 3439886**

(43) Veröffentlichungstag der Anmeldung:
**07.05.86 Patentblatt 86/19**

(45) Bekanntmachung des Hinweises auf die
Patenterteilung:
**09.01.91 Patentblatt 91/02**

(84) Benannte Vertragsstaaten:
**CH DE FR GB IT LI SE**

(56) Entgegenhaltungen:
**DE-A-2 224 413**
**FR-A-2 139 386**
**US-A-3 746 933**
**US-A-3 950 060**

(73) Patentinhaber: **Siemens Aktiengesellschaft**
**Wittelsbacherplatz 2**
**D-8000 München 2 (DE)**

(72) Erfinder: **Glomb, Kurt, Dipl.-Ing. (FH)**
**Nelkenstrasse 11**
**D-8034 Germering (DE)**
Erfinder: **Niggl, Heinz, Ing. grad.**
**Lindenberg 149**
**D-8134 Pöcking (DE)**
Erfinder: **Pelzl, Leo, Dipl.-Ing. (FH)**
**Alpenblickstrasse 5**
**D-8150 Holzkirchen (DE)**
Erfinder: **Zell, Karl, Dipl.-Ing. (FH)**
**Moritz-von-Schwind-Weg 80**
**D-8134 Niederpöcking (DE)**

EP 0 180 056 B1

Courier Press, Leamington Spa, England.

# Beschreibung

Die Erfindung betrifft eine Rückwandverdrahtung für elektrische Baugruppen, bestehend aus einer Rückwandleiterplatte mit eingesetzten Kontaktmessern und darauf aufsteckbaren als einseitig offene rechtwinklige Gehäuse ausgebildeten Zentrierleisten zur Aufnahme von Federleisten, die mit elektrischen Baugruppen fest verbunden sind, wobei die Zentrierleisten im Boden Durchtrittsöffnungen für die Kontaktmesser aufweisen.

Derartige auf die Rückwandleiterplatte aufsteckbare Zentrierleisten zur Aufnahme entsprechender Federleisten müssen mehrere Forderungen erfüllen. Sie sollen leicht aufsteckbar sein, im aufsteckten Zustand aber gut halten. Muß beim Aufstecken der Zentrierleisten ein zu großer Druck ausgeübt werden, so kann es passieren, daß die Kontaktmesser aus der Rückwandleiterplatte herausgedrückt werden, da diese nur eine begrenzte Haltekraft aufweisen. Auch soll bei aufgesteckten Zentrierleisten der Austausch einzelner Kontaktmesser ohne Beschädigung der Zentrierleisten möglich sein.

Die DE—A—2 224 413 zeigt ein Kontaktorgan mit einem Befestigungabschnitt, wobei einem seitlichen Vorsprung, beim Befestigen in einer Leiste, in einen Schlitte in dem Befestigungsabschnitt gewölbt wird.

Aufgabe der vorliegenden Erfindung ist es daher, eine Rückwandverdrahtung aus Rückwandleiterplatte und Zentrierleisten anzugeben, bei der die Zentrierleisten ohne großen Kraftaufwand aufgesteckt werden können und im aufgesteckten Zustand gut auf der Rückwandleiterplatte halten.

Diese Aufgabe wird für eine Rückwandverdrahtung der eingangs genannten Art erfindungsgemäß dadurch gelöst, daß neben jeder Durchtrittsöffnung für ein Kontaktmesser eine zusätzliche Öffnung vorgesehen ist, welche durch einen Steg von der Durchtrittsöffnung für das Kontaktmesser getrennt ist, und daß das Kontaktmesser auf einer Seite eine kalottenförmige Pocke aufweist, die nach dem Aufstecken der Zentrierleisten gegen den Steg drückt.

Bei der erfindungsgemäßen Rückwandverdrahtung erfolgt die Halterung des Kontaktmessers in der Zentrierleiste mittels des federnden Steges im Boden der Zentrierleiste sowie mittels der kalottenförmigen Pocke auf den Kontaktmesser. Dadurch liegen definierbare Haltekräfte vor. Durch die Nachgiebigkeit des federnden Steges läßt sich die Zentrierleiste auf vorbestückte Rückwandleiterplatten ohne großen Kraftaufwand aufstecken. Dadurch, daß der Steg elastisch nachgibt, können die Kontaktmesser ohne Einbuße der Haltefunktion ausgetauscht werden.

Eine zweckmäßige Ausgestaltung der erfindungsgemäßen Rückwandverdrahtung ist dadurch gekennzeichnet, daß alle oder ein Teil der zusätzlichen Öffnungen im Boden der Zentrierleisten durch Ansätze eingeengt sind. Dadurch wird beim Montieren der Zentrierleiste ein falsches Aufsetzen der Zentrierleiste auf die Kontaktmesser der Rückwandleiterplatte verhindert.

Eine weitere zweckmäßige Ausgestaltung der erfindungsgemäßen Rückwandverdrahtung ist dadurch gekennzeichnet, daß die Durchtrittsöffnungen für die Kontaktmesser an einer Längsseite eine Aussparung aufweisen, wodurch die möglichkeit besteht, daß auch Kontaktmesser mit elastischen Einpresszonen verwendet werden können.

Im folgenden wird die Erfindung anhand eines in der Zeichnung dargestellten Ausführungsbeispieles näher erläutert.

Es zeigen

Fig. 1 ein Teil einer Rückwandleiterplatte mit Kontaktmessern sowie eine Zentrierleiste,

Fig. 2 einen Querschnitt der erfindungsgemäßen Zentrierleiste mit einem eingeschobenen Kontaktmesser, und

Fig. 3 eine teilweise Draufsicht auf eine Zentrierleiste gemäß der vorliegenden Erfindung.

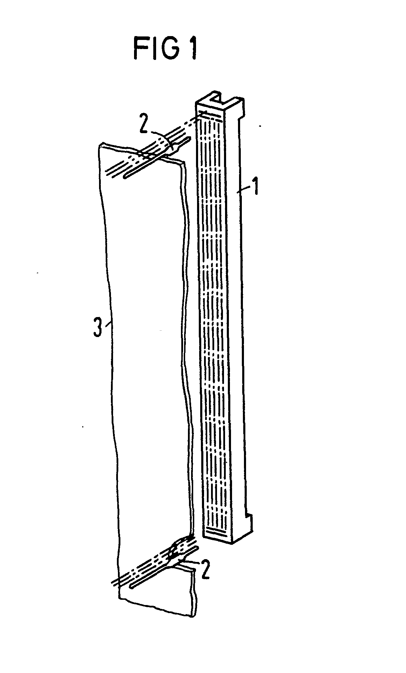

Fig. 1 zeigt zum besseren Verständnis den prinzipiellen Aufbau einer Rückwandverdrahtung, bei der eine Zentrierleiste 1 auf eine mit Kontaktmessern zwei versehene Rückwandleiterplatte 3 aufgesteckt wird.

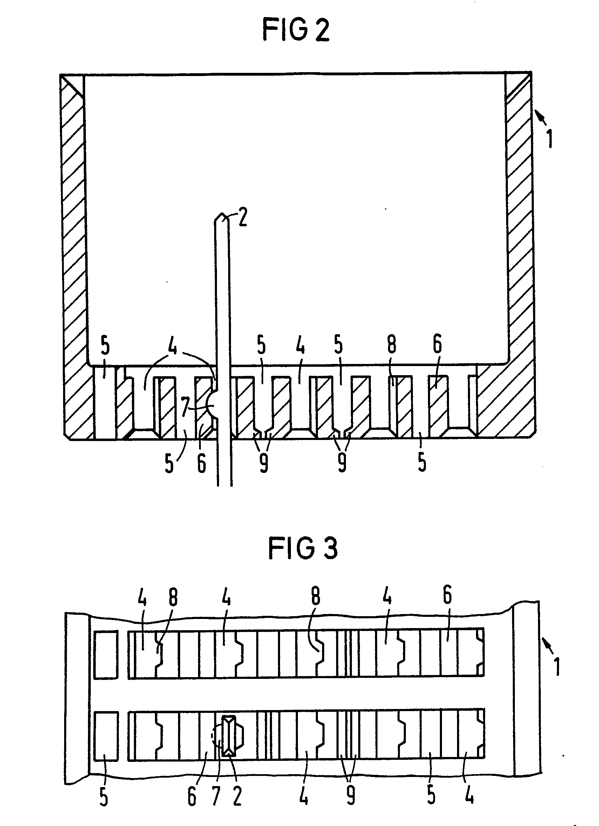

Fig. 2 zeigt einen Querschnitt durch eine Zentrierleiste gemäß der vorliegenden Erfindung, die mit erfindungsgemäßen Kontaktmessern 2 bestückt ist. In der Darstellung wurde nur ein Kontaktmesser 2 mit einer kalottenförmigen Pocke 7 eingezeichnet. Beim Aufsetzen der Zentrierleiste 1 auf die Rückwandleiterplatte 3 dringen die Kontaktmesser 2 durch die Durchtrittsöffnungen 4, wie sich aus der Fig. 3 entnehmen läßt. Neben jeder Durchtrittsöffnung 4 in der Zentrierleiste 1 ist eine zusätzliche Öffnung 5 vorgesehen, wodurch neben jeder Durchtrittsöffnung 4 ein federnder Steg 6 entsteht. Im aufgesteckten Zustand der Zentrierleiste 1 drückt die Pocke 7 des Kontaktmessers 2 gegen diesen Steg. Dadurch liegen genau definierbare Haltekräft für die Kontaktmesser in den Zentrierleisten 1 vor.

Wie sich der Fig. 3 entnehmen läßt haben die Kontaktmesser 2 in den Durchtrittsöffnungen 4 ein seitliches Spiel, um einen Toleranzausgleich in Längsrichtung zu schaffen. Dadurch, daß der federnde Steg 6 beim Aufstecken der Zentrierleiste 1 auf die Kontaktmesser 2 nachgibt, läßt sich bei der erfindungsgemäßen Rückwandverdrahtung die Zentrierleiste 1 leicht auf die Kontaktmesser 2 aufstecken.

Um ein falsches Aufstecken zu vermeiden, d.h. um zu vermeiden daß die Kontaktmesser 2 versehentlich in die zusätzlichen Öffnungen 5 eindringen, können alle oder ein Teil der zusätzlichen Öffnungen 5 an ihren unteren Enden mit Ansätzen 9 versehen werden. Durch diese Ansätze 9 werden die Federeigenschaften des Steges 6 nicht berührt.

Die Durchtrittsöffnung 4 für die Kontaktmesser 2 weisen zusätzlich noch Aussparungen 8 auf. Diese sind lediglich für den Fall vorgesehen, daß Kontaktmesser mit elastischen Einpreßzonen Verwendung finden.

## Patentansprüche

1. Rückwandverdrahtung für elektrische Baugruppen, bestehend aus einer Rückwandleiterplatte mit eingesetzten Kontaktmessern und darauf aufsteckbaren als einseitig offene rechtwinklige Gehäuse ausgebildeten Zentrierleisten zur Aufnahme von Federleisten, die mit elektrischen Baugruppen fest verbunden sind, wobei die Zentrierleisten im Boden Durchtrittsöffnungen für die Kontaktmesser aufweisen, dadurch gekennzeichnet, daß neben jeder Durchtrittsöffnung (4) für ein Kontaktmesser (2) eine zusätzliche Öffnung (5) vorgesehen ist, welche durch einen Steg (6) von der Durchtrittsöffnung (4) für das Kontaktmesser (2) getrennt ist, und daß das Kontaktmesser (2) auf einer Seite eine kalottenförmige Pocke (7) aufweist, die nach dem Aufstecken der Zentrierleisten (1) gegen den Steg (6) drückt.

2. Rückwandverdrahtung nach Anspruch 1, dadurch gekennzeichnet, daß alle oder ein Teil der zusätzlichen Öffnungen (5) im Boden der Zentrierleisten (1) durch Ansätze (9) eingeengt sind.

3. Rückwandverdrahtung nach Anspruch 1, dadurch gekennzeichnet, daß die Durchtrittsöffnungen (4) für die Kontaktmesser (2) an einer Längsseite einer Aussparung (8) aufweisen.

## Revendications

1. Câblage de panneau arrière pour des modules électriques, constitué par une plaquette à circuits imprimés formant panneau arrière, sur laquelle sont montés des couteaux de contact, et des réglettes de centrage, qui peuvent être enfichées sur les couteaux, qui sont réalisés sous la forme d'un boîtier rectangulaire ouvert unilatéralement et qui servent à loger des réglettes élastiques, qui sont reliées rigidement à des modules électriques, les réglettes de centrage possédant, dans leur fond, des ouvertures de passage pour des couteaux de contact, caractérisé en ce qu'à côté de chaque ouverture de passage (4) pour un couteau de contact (2) est prévue une ouverture supplémentaire (5), qui est séparée, par une barrette (6), de l'ouverture de passage (4) pour le couteau de contact (2), et que le couteau de contact (2) possède, sur une face, un bombement en forme de calotte sphérique (7), qui, après l'enfichage de la réglette de centrage (1), s'appuie entre la barrette (6).

2. Câblage de panneau arrière suivant la revendication 1, caractérisé par le fait que la totalité ou une partie des ouvertures supplémentaires (5) ménagées dans le fond de la réglette de centrage (2) sont rétrécies par suite de la présence d'appendices saillants (9).

3. Câblage de panneau arrière suivant la revendication 1, caractérisé par le fait que les ouvertures de passage (4) pour les couteaux de contact (2) possèdent un évidement (8) au niveau d'une face longitudinale.

## Claims

1. Backplane wiring for electrical assemblies, consisting of a backplane printed circuit board having inserted contact blades and centring strips for accepting spring clips which are rigidly connected to electrical assemblies, which strips are pluggable onto said contact blades and are constructed as rectangular housings open at one side, the centring strips having openings in the floor for the passage of the contact blades, characterized in that next to every opening (4) for the passage of a contact blade (2) an additional opening (5) is provided which is separated from the opening (4) for the passage of the contact blade (2) by a web (6), and in that the contact blade (2) has a calotte-shaped pock (7) on one side which presses against the web (6) after the centring strip (1) has been plugged on.

2. Backplane wiring according to Claim 1, characterized in that all or some of the additional openings (5) in the floor of the centring strips (1) are constricted by shoulders (9).

3. Backplane wiring according to Claim 1, characterized in that the openings (4) for the passage of the contact blades (2) have a recess (8) on one longitudinal side.

# FIG 1

# FIG 2

# FIG 3